# EUROPEAN PATENT SPECIFICATION

(11) **EP 3 137 837 B1**
(45) Date of publication and mention of the grant of the patent: **28.02.2018**
(21) Application number: 14828536.4
(22) Date of filing: 19.12.2014
(51) Int. Cl.: F28F 3/12, H01L 23/34, H05K 7/20, F28F 21/00, G21G 1/00, F01P 3/02

(54) **METHOD FOR PRODUCING A HEAT EXCHANGER AND RELEVANT HEAT EXCHANGER**
VERFAHREN ZUR HERSTELLNUG EINES WÄRMETAUSCHERS UND ENTSPRECHENDER WÄRMETAUSCHER
PROCEDE DE FABRICATION D'UN ECHANGEUR DE CHALEUR ET ECHANGEUR DE CHALEUR RESPECTIVE

(30) Priority: 30.04.2014 IT MI20140805
(43) Date of publication of application: 08.03.2017
(73) Proprietor: Istituto Nazionale di Fisica Nucleare, 00044 Frascati (IT)
(72) Inventor: MASTINU, Pierfrancesco, I-35027 Noventa Padovana (PD) (IT); MARIGO, Selvino, I-35020 Brugine (PD) (IT)
(74) Representative: Lisa, Elisabetta
(86) International application number: PCT/IB2014/067156
(87) International publication number: WO 2015/166320

(56) References cited:
- EP-A1- 1 548 133
- EP-A2- 2 151 653
- WO-A1-2008/107743
- CH-A5- 677 293
- US-A- 5 829 516
- US-A1- 2006 113 063
- US-A1- 2007 070 605

## Description

### TECHNICAL FIELD

The present invention relates to the field of heat exchangers and to methods for producing them.

More precisely the present invention relates to microchannel heat dissipating systems.

Particularly, the invention relates to a method according to the preamble of claim 1 and to a heat exchanger obtained by such method as disclosed by WO 2008/107743 A1. The invention is preferably and advantageously applied for cooling systems producing radionuclides, particularly radiopharmaceuticals, for cooling heat engines, for cooling electronic components and circuits, for producing power targets for medical, energy and basic research applications, and for material treatment.

### PRIOR ART

Nowadays in many technological fields it is necessary to dissipate high specific powers (meanings power per unit surface or volume).

For example, in the electronic field, in order to allow the current electronic components to perform their tasks more and more quickly, high-powered integrated circuits have been produced; however such circuits generate such heat fluxes that, if they are not efficiently removed , cause the maximum allowable operating temperatures to be exceeded and the circuits to be consequently damaged.

In this field, it has been known for more than thirty years, to use microchannel heat sinks, that work in a rather simple manner: in the integrated circuits, and more precisely in their thin substrate made of suitable thermally conductive material, microchannels are obtained by mechanical machining operation (having a diameter with a size of few hundreds of micron and close with each other as much as possible) wherein a cooling fluid flows. The heat generated by the electronic component coupled to the heat sink is transferred to the cooling fluid by forced convection with a high cooling rate, by means of the decrease in the thickness of the thermal boundary layer due to the microscopic dimension of the channels and to the consequent decrease in the convective resistance to heat transfer. By the use of the microchannels, it is possible to operate the heat sinks with high pressures of the cooling fluid, while maintaining the extremely reduced thicknesses of the tubes, in favor also of the convective coefficient of the part of heat thermal conduction.

An example of a heat sink is described in the European Patent application published with n. EP 1 548 133 A1; particularly such document describes a method for producing a heat exchanger, comprising the steps of:
- forming at least one channel inside a plate having an upper face and a lower face, said at least one channel extending through the plate between the upper face and the lower one,
- inserting, with radial clearance, a tube into the channel
   so that both tube ends protrude out of the channel and then,
- achieving a press fit of the tube within the channel by shrinking the section of the channel and/or expanding the section of the tube, such to fix the tube inside the channel.
The method described above, providing to make holes instead of finns or grooves starting from a side wall of the plate, has limits regards the geometry of the channels, the inter-distances between the channels, the maximum dimensions that can be obtained, uniformity of the dimensions and orientation of the channels.

From CH 677 293 A5, WO 2008/107743 A1 and EP 2 151 653 A2 it is also known to insert tubes into a channel formed inside a plate, whereby the channels have an open clearance at one surface of the plate. Also these heat exchangers comprise macrochannels. EP 2 151 653 A2 and US2006/0113063 A1 disclose heat exchangers with microchannel structures, which are formed by micro machining without inserted tubes. Due to technical reasons, by perforating a plate on the side with a micro-tip, it is possible to obtain only micro-holes with a substantially circular section and very short length , it is not possible to obtain inter-distances between the micro-holes lower than 1 mm (with a penetration depth of at least 2 cm), since directionality drops as the perforation goes on, and depending on the type of material, not perfectly equal micro-holes are obtained.

Therefore there is the need of producing heat exchangers with a high heat exchange efficiency, whose microchannels can take several geometries, have uniform dimensions, keep a constant direction and have a small inter-distance preferably lower than 1 mm.

### OBJECTS AND SUMMARY OF THE INVENTION

It is the object of the present invention to overcome the drawbacks of the prior art related to the production of heat exchangers.

Particularly it is the object of the present invention to provide a method for producing heat exchangers with a high efficiency heat exchange allowing microchannels to be formed having different geometries depending on the needs of use.

It is an object of the present invention also to provide a method for producing heat exchangers with microchannels whose dimensions are uniform throughout their length.

It is also an object of the present invention to provide a method for producing microchannel heat exchangers wherein the microchannels have a very small inter-distance with respect to each other, preferably smaller than 1 mm.

It is also an object of the present invention to provide a method for producing microchannel heat exchangers wherein the channels have different shapes dimensions and accommodation on the substrate in different geometries.

It is also an object of the present invention to provide a method for producing microchannel heat exchangers by using materials even very different from each other, both for the substrate and for the tube.

These and other objects of the present invention are achieved by a method for producing a heat exchanger and a heat exchanger embodying the characteristics of the annexed claims. In one embodiment, the microchannels are formed in a plate having an upper and a lower face. The method provides to form each microchannel by creating a groove on one face of the plate, for example the upper one. The groove, in a plane orthogonal to the development plane of the groove, will have an open extremity facing the face of the plate and a blind extremity placed inside the plate. In order to form the microchannel, the blind extremity of the groove is machined (simultaneously with or in a different moment than the generation of the groove) in order to create a volume of a suitable size to house the tube.

This solution provides the advantage of accurately forming the microchannels, since it is not necessary to use a drill with a micro-tip perforating the hole in the development direction of the microchannel.

In a particularly advantageous embodiment the microchannels are made by wire electrical discharge machining of the plate.

The wire electrical discharge machining allows microchannels with sections (in the plane transverse to the development plane) of different shapes, for example polygonal ones, to be obtained. Polygonal sections are particularly efficacious for retaining a tube inserted in the microchannel by pressing it (and therefore in a quite simple manner) in the groove formed on the face of the plate.

On the contrary circular or semicircular sections are particularly efficacious for improving the heat exchange with circular tubes.

The use of the wire electrical discharge machining apparatus allows an almost circular groove to be machined, it being necessary only one open cut for inserting the wire, whose diameter can be up to 1 micron.

In a particularly inexpensive embodiment, that does not require too much expensive apparatuses, the microchannels are formed by milling the plate by using a milling cutter comprising a thin body with a head enlarged towards a free end of the milling cutter. The plate therefore is milled by moving the milling cutter in a plane orthogonal to the upper face of the plate, such that the thin body of the milling cutter creates the groove in the face of the plate while the enlarged head of the milling cutter machines the blind extremity of the groove in order to create the seat for the tube.

At most the thin body may have punctiform dimensions, such that the milling cutter has a conical base.

By this technique it is therefore possible to produce grooves also on non-flat surfaces and with any shape and variable direction.

The invention further relates to a heat exchanger obtained according to the method such as described and claimed below.

Such heat exchanger, due to the high cooling capacity per cm², can be produced with small dimensions and therefore it can be advantageously put in contact with or integrated with the devices to be cooled. For example in one embodiment the heat exchanger can be integrated with an integrated circuit to be cooled. In this embodiment, therefore, the microchannels and the cooling tubes are made on the same substrate on which the integrated circuit is made.

In one embodiment the heat exchanger is provided with microchannels obtained by means of cuts on the upper face of the plate, said cuts being machined in their blind extremity in order to create a volume of a suitable size to house corresponding micro-tubes that are calendered therein.

In one embodiment, the heat exchanger according to the invention is used in a system for producing radionuclides, precisely for cooling the target on which a beam of particles is irradiated such to generate different elements by nuclear reaction.

Due to the high efficiency of the heat exchanger, it is possible to place it in contact with the target for cooling it, for example by depositing using known methods (rolling, pressure, evaporation, sputtering) the material to be irradiated directly on the substrate of the exchanger (thus it is integrated with the target); thus it is possible to increase the production of radionuclides by operating the system with beams of high specific intensity particles without the thermal power conveyed in the target melting it and by using less material (which usually is a very expensive material). Another advantage deriving from the possibility of dissipating high specific powers is that the concentration of activities is very high, in favor also of the quality of the precursor of the radionuclide produced.

In one embodiment the heat exchanger according to the invention is used for cooling a cylinder head or the cylinder of a combustion engine of a motor vehicle or a motorcycle.

In this manner, namely due to the efficiency of the heat exchange accomplished, it is possible to considerably reduce the dimensions of the engine and to increase its efficiency, consequently reducing the overall dimensions, costs and weight.

In one embodiment, the heat exchanger is applied to a power target for medical applications such as ABNCT (accelerator based neutron capture therapy).

Therefore the present invention relates also to an apparatus for producing radionuclides, a heat engine, particularly a combustion engine, and a power neutron generator (target) for ABNCT comprising one heat exchanger such as described and claimed below.

Further advantageous characteristics of the present invention will be more clear from the following description and from the annexed claims.

### BRIEF DESCRIPTION OF THE DRAWINGS

The invention will be described below with reference to non-limiting examples, provided by way of example and not as a limitation in the annexed drawings. These drawings show different aspects and embodiments of the present invention and, where appropriate, reference numerals showing like structures, components, materials and/or elements in different figures are denoted by like reference numerals.
Figure 1 is a flow chart showing the method for producing a heat exchanger according to the present invention;
Figure 2 is a schematic perspective view of the heat exchanger according to one embodiment of the present invention;
Figure 3a is a schematic perspective view of the heat exchanger according to an alternative embodiment of the present invention;
Figures 3b to 3f are alternative profiles of the microchannels of the heat exchanger according to the present invention; and
Figure 4 is a schematic view of an apparatus for producing radionuclides comprising a heat exchanger according to the present invention.

### DETAILED DESCRIPTION OF THE INVENTION

While the invention is susceptible of various modifications and alternative forms, some disclosed relevant embodiments are shown in the drawings and will be described below in detail.

It should be understood, however, that there is no intention to limit the invention to the specific embodiments disclosed, but, on the contrary, the intention of the invention is to cover all modifications, alternative constructions and equivalents falling within the scope of the invention as defined in the claims.

Therefore in the description below the use of "for example", "etc", "or", "otherwise" indicates non-exclusive alternatives without limitation unless otherwise defined; the use of "also" means "including, but not limited to" unless otherwise defined; the use of "including/comprising" means "including/comprising but not limited to," unless otherwise defined.

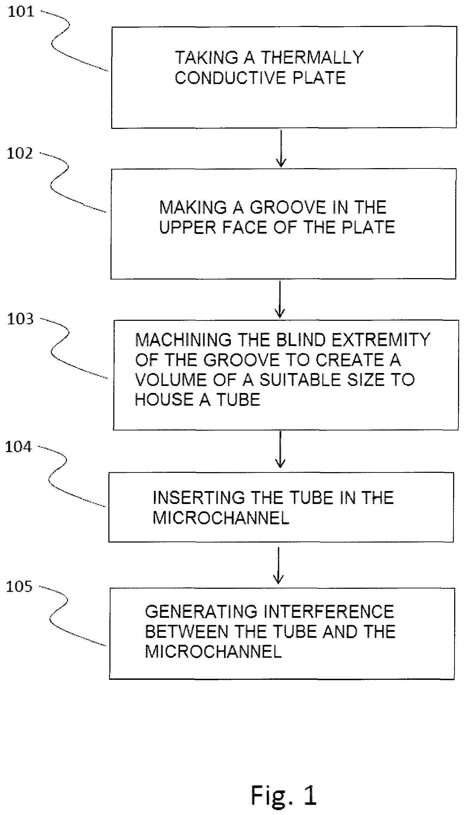

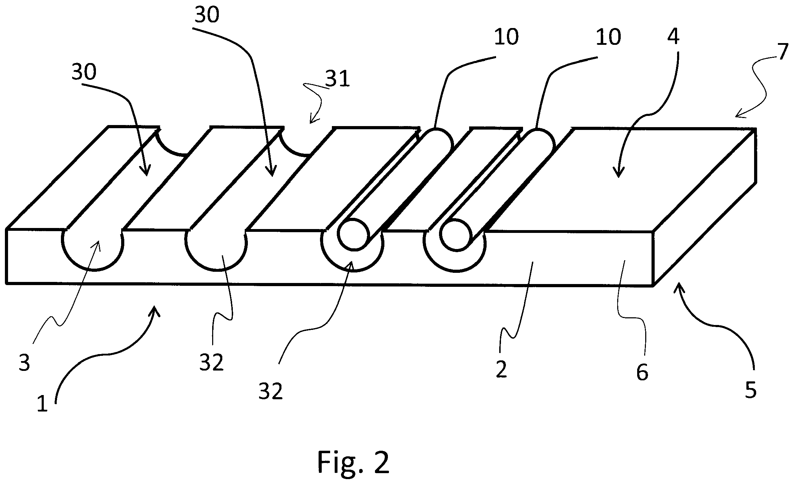

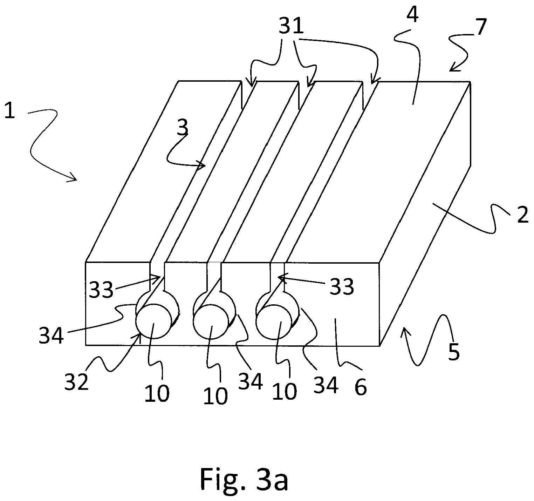

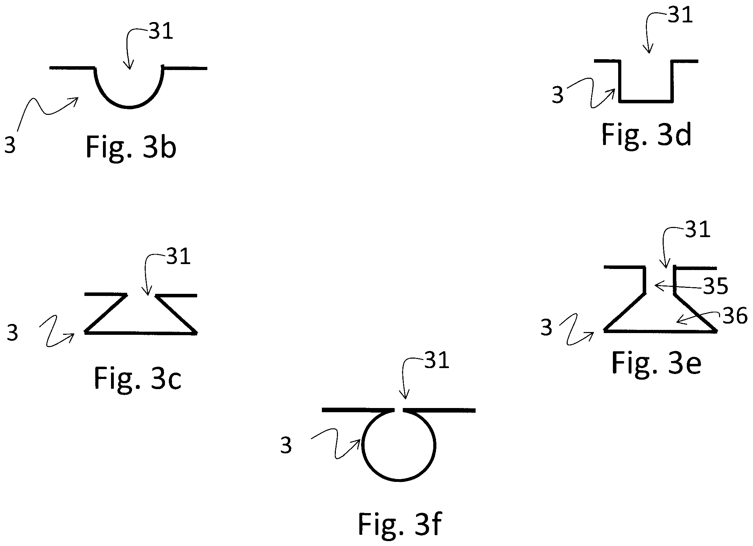

The flow chart of figure 1 allows a method for producing a heat exchanger 1 to be appreciated in its general aspect, for example of the type shown in figures 2 or 3.

According to such method, the heat exchanger 1 is produced starting from a thermally conductive plate 2, that is a block made of a material having a good thermal diffusivity, such as for example a metal (e.g. cooper) or diamond, and therefore it is able to properly absorb heat from the devices with which it is put in contact. Such material is preferably thin, thin enough for its mechanical support and for housing micro-tubes.

The plate 2 has an upper face 4 and a lower face 5; the lower face is flat and continuous and therefore it is particularly fit for being placed in contact with a device to be cooled. For example the lower face 5 can be put in contact with a processor or another device to be cooled. The grooves on which the tubes have to be calendered can be also directly produced on the substrate of the electronic device.

The method provides to form a plurality of microchannels 3 developed inside the plate 2 between the upper face 4 and the lower face 5. Such microchannels 3 are intended to receive a respective tube wherein a cooling fluid will flow, with the heat exchanger in use.

Obviously the number of microchannels, their orientation and the number of tubes are not a limitation of the present invention, for example it will be possible to provide a plate 2 with a single microchannel 3 developing along several directions, for example by winding around itself or following broken lines. As an alternative it is possible to provide several microchannels crossing with each other to form a grid where one or more tubes are housed which do not necessarily occupy each individual microchannel for all its length.

Therefore the method provides to take a thermally conductive plate (step 101), particularly a plate made of a material with a thermal conductivity higher than 300 W/mK.

Then the microchannels 3 are formed by making (step 102) grooves 30 in the upper face 4 of the plate 2. The grooves 30 are cuts made in the upper face of the plate 2 and extending, in a direction perpendicular to the face 4 and precisely from the outside to the inside of the plate, between an open extremity 31 opening on the upper face 4 of the plate 3 and a blind extremity 32 placed inside the plate 2.

In the example of figure 2, each microchannel 3 extends for all the width of the plate 2 therefore opening not only on the upper face 4 of the plate 2 but also on the two side faces (denoted by references 6 and 7) that connect the upper face 4 and lower face 5 of the plate 2. The microchannels 3, in this embodiment, therefore are continuous grooves touching three faces of the plate 2.

The method provides (step 103) to machine the blind extremity 32 of each groove to create a volume with a size suitable to house a tube 10 wherein a cooling fluid will flow intended to remove heat from the plate by convention.

In one embodiment, the tube 10 is preferably a cylindrical microtube, with an inner diameter lower than 500 µm and more preferably ranging from 500 µm to 100 µm. Although the shape and the dimensions of the microtube 10 are not binding for the purposes of the present invention, the cylindrical shape and the small dimensions are particularly advantageous, particularly by using cylindrical microtubes with an inner diameter lower than 500 µm it is possible to improve the heat exchange between the cooling fluid and the plate. In tubes with such dimensions, the movement of the fluid in the microtube allows the fluid layer that tends to adhere on the inner walls of the tube to be broken; this layer (that tends to build in tubes with greater dimensions) is composed of substantially still molecules of fluid, therefore they are not able to transport heat by convention. By breaking such layer, the convective heat transfer capacity and therefore the exchanger performances are improved.

Regardless of physical phenomena, the improvement in the performances of the heat exchanger in this type of tubes is shown by experimental results that, as it is known per se from scientific literature (see e.g. Int. J. Heat Mass Transfer. Vol. 37, No. 2, pp321-332, 1994) denote an improvement in the performances of a heat exchanger when it is provided with this type of tubes.

Then the method provides (step 104) to insert a tube 10 inside the microchannel 3 and then, to generate interference (step 105) between the tube 10 and the microchannel 3 such to fix the tube 10 into the microchannel 3.

The insertion of the tube in the microchannel and the following interference can be accomplished in many ways, for example by thermal expansion of the tube, expansion by pressure or another type described in EP1548133.

In one embodiment, the tube 10 is inserted in the microchannel through the opening 31 of the microchannel 3. In one embodiment the tube 10 has an outer diameter slightly greater than the diameter of the microchannel 3 therefore in order to be inserted it is cooled beforehand with a fluid at a lower temperature, for example liquid nitrogen, such to reduce its outer diameter, then it is inserted through the opening 3, for example by a light pressure. When the temperature of the tube is brought again to room temperature, the tube 10 expands and it interferes with the inner walls of the microchannel 3.

As an alternative to the insertion through the opening in the face 4, after its thermal shrinkage, the tube 10 is lubricated and it slides into the microchannel 3 by inserting it into one of the openings of the microchannel opening on the side faces 6 or 7.

The tube can be inserted in the plate during a wire drawing process after which the tube, once stretched, is made thinner such to enter the microchannel provided that the characteristics of the materials of the plate and of the tube allow this operation.

With reference now to the machining of the microchannel 3 (steps 102 and 103 of the method of figure 1), the groove in the face 4 and the machining of the blind extremity of the groove can be performed in several ways.

In one embodiment, such machining for forming the microchannel is performed by wire electric discharge machining. This technique allows a wire with a length even more than 1 meter to be used by means of which microchannels 3 with constant dimensions and direction are obtained. Such technique is particularly efficacious for machining plates 2 made of diamond.

By the wire electric discharge machining in the upper part 4 of the plate 2 a cut with a width of 0.2 mm or even less is obtained depending on the dimension of the wire, such to allow the wire to enter in the plate 2.

The microchannels 3 obtained by electric discharge machining preferably have a semicircular profile - in the plane orthogonal to the upper face 4 - such as shown in Figures 2 and 3b; the semicircular profile is preferred since it allows a more effective heat exchange.

Such circular profile however may not be effective if the opening 31 is too large, as a matter of fact, in the case of the insertion of a tube with the outer dimensions greater than the diameter of the groove due to the expansion of the tube, in order to generate the interference with the groove the tube could be lifted from its seat and the contact with the plate would be reduced, with a consequent reduction in the efficiency of the heat exchange.

For this reason, in the embodiment shown in figure 3a the circular profile is obtained deeply in the plate, such that at least 60% and preferably 80% and ≅100% (this number never reachable, of course) of the circle inscribing such profile is placed within the plate 2.

In the example of figure 3a, therefore the groove 3 has, in a plane orthogonal to the face 4, a profile composed of a straight channel 33 starting with the opening 31 in the face 4 of the plate and ending in a circular profile 34.

In the preferred embodiment, the straight channel 33 has a null length and the circular profile 34 closes in a way tangent to the face 4 of the plate 2. The circular profile 34 therefore is open only at the opening 31, which can have a width lower than 10 µm and preferably ranging from 1 to 2 µm, such as shown in figure 3f.

By using the wire electric discharge machining, however it is possible to obtain microchannels 3 with several geometries, particularly polygonal shapes such as a square (shown in figure 3d) or a trapezium (shown in figure 3c), depending on needs of use and on the different shapes of the device to be cooled and/or of the available tube.

As said above, the microchannels can be made with different techniques, for example the microchannel in figure 3a can be obtained in two separate phases, firstly by forming the channel 33, for example by cutting (with a blade or electric discharge machining) or by milling the plate 2, and then by enlarging the blind extremity 32 of the channel 33 made in this manner.

At the same time, the wire drawing of the tube can be used, when it is possible, to create interference between the tube and the groove.

According to another embodiment, the microchannels are formed by milling the plate by using a milling cutter comprising a thin body with a head enlarged towards a free end of the milling cutter. The method provides to mill the plate by a relative movement of the milling cutter in a plane preferably orthogonal to, or substantially orthogonal to, (however not parallel to) the upper face of the plate, such to form a microchannel whose profile in a plane orthogonal to that of the face 4 is shown in figure 3e. The thin body of the milling cutter forms the channel 35 while the enlarged head of the milling cutter, for example a conical head, forms the seat 36 intended to house the tube 10.

Therefore depending on the type of milling cutter used it is possible to obtain different profiles, for example it is possible to obtain microchannels with the profile of figure 3c or that of figure 3d.

Here it has to be noted that unlike the method mentioned above that provides the blind extremity 32 to be machined in a phase different from the machining of the groove, in the case of a milling operation, the machining of the groove 30 and the profiling of its blind extremity 32 have not to follow necessarily different machining moments. For example if the profile of figure 3d is machined by a milling operation, it will be possible to use a cylindrical milling cutter which, starting to mill the plate from a side leading face, for example the face 6, and by moving in the direction of an end side face, for example face 7, will contemporaneously machine the three sides of the square profile of figure 3d. If a microchannel with the profile of figure 3e is machined by a milling operation, in this case the enlarged head will contact the plate before the thin body of the milling cutter, therefore the seat 36 for the tube 10 will be formed before the channel 35.

Therefore it is clear from the above that for the purposes of the present invention it is important to form a groove along a face of the plate, such groove being characterized by an enlarged blind extremity intended to house the tube 10 where the cooling fluid will flow. The methods and the order for making the several components of the groove can be different and not necessarily limited to those described above.

In order to allow the heat exchanger 1 to work efficiently, during the operation inside each of the tubes 10 a cooling fluid flows, for example a cooling gas or water or a eutectic alloy of tin/indium/gallium; preferably said cooling fluid is liquid metal that, advantageously improves the heat exchange by increasing the performance of the heat exchanger of the invention by at least a factor of 3.

In one embodiment, the heat exchanger 1 therefore is provided also with means (for example a pump and a tank) intended to allow a cooling fluid to flow by force in the tubes 10.

The tubes 10 can be connected with each other in series or in parallel. In the case of a plurality of microchannels it is advantageous to connect them in such a manner that the fluid flows alternately in opposite directions avoiding thermal gradients between the two extremities (6 and 7 in figure 2).

With reference again to Figure 3a, where the heat exchanger 1 according to one embodiment of the present invention is schematically shown, it has to be noted that said heat exchanger 1 comprises:;
- a plate 2 in turn comprising:
   - an upper face 4 and a lower face 5
   - at least one microchannel 3 obtained in the plate 2 and extending in the plate 2 between the upper face 4 and the lower face 5,
- a tube 10 inserted in the microchannel 3 and fixed thereto.

The microchannel 3 throughout all its development length has an opening 31 which opens on the upper face 4 of the plate 2 and having such dimensions not to allow the tube 10 to come out from such opening.

In a preferred embodiment, the plate 2 is made of diamond and the tubes 10 are made of copper. The diamond is a material having a thermal conductivity 20 times higher than the copper and it has a thermal expansion lower than the cooper (3 ·10⁻⁶ K⁻¹ of the diamond, versus 51 ·10⁻⁶ K⁻¹ of the cooper); therefore in the operating conditions, when the plate absorbs heat from the device to be cooled, the tube 10 expands more than the microchannel 3, improving the thermal contact and therefore the heat exchange. Moreover the diamond, since it is a material with a high thermal diffusivity, allows the heat to be spread very efficaciously, which therefore is transferred to all the tube 10; the diamond allows also a more rigid and strong structure to be obtained.

As an alternative, the tube 10 is made of diamond that, as said above, is a material having several properties.

As an alternative the tube 10 is made of niobium or steel alloys, which allows a liquid metal to be used as the cooling fluid, such to improve the heat exchange.

If it is possible to operate the plate 2 with higher temperature values (particularly exceeding 100°C), it will be possible to use materials of different type for the tube 10, such as graphite, tantalum and tungsten; the same plate 2 can be made of other materials such as fullerenes.

Other materials can also be selected depending on the operating needs, such as the use of chemically aggressive fluids, high thermal stability etc., as it will be clear to the person skilled in the art.

The embodiments shown in the figures described above provide both the microchannels 3 and the corresponding tubes 10 to extend throughout all the length of the plate 2, such that both the ends of the tube 10 protrude outside of the microchannel on opposite side faces of the plate 2. However it is possible to accomplish several different arrangements, for example with both the ends of the tube 10 protruding from the microchannel on the same side face of the plate 2, and also other ones that will be clear to the person skilled in the art.

The heat exchanger 1 according to the present invention can be used in several fields, where it is necessary to dissipate high specific powers; by way of example and not as a limitation we mention:
- heat sinks for computer CPUs
- power dissipation generally on electronic devices to be miniaturized (the direct use of silicon instead of copper or diamond as the substrate of the plate 2 can be assumed),
- power targets for producing neutrons for "Boron Neutron Capture Therapy-BNCT" with surface deposition of lithium or beryllium,
- production of radionuclides particularly for medical use,
- dissipation in internal combustion engines,
- "beam dump" for particle beams,
- heat dissipation systems for radioactive wastes,
- dissipation systems for concentrator solar photovoltaic system,
- heat transfer systems for solar thermal system,
- cooling systems for tips of welders / laser cutting machines and TIG/MIG machines,
- "plasma-facing components",
- "high heat-load optical components",
- X ray devices, and
- Power Electronics in hybrid vehicles
- Systems for thermally treating materials,
- Cooling devices for laser diode arrays.

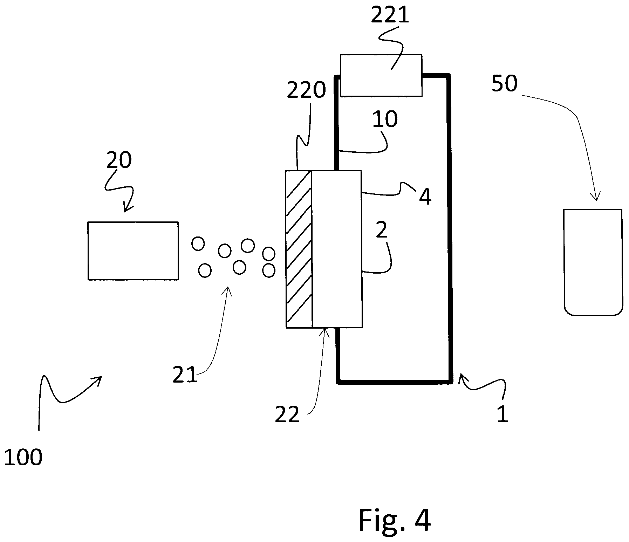

A preferred and advantageous application of the heat exchanger 1 according to the present invention is the one schematically shown in Figure 4, showing an apparatus for producing radiopharmaceuticals such as described in the Italian Patent application n. MI2014A000145 to the same applicant.

Said apparatus for producing radiopharmaceuticals, denoted by the reference numeral 100 in Figure 4 comprises:
- a primary accelerator or driver 20
- a target 22, and
- a chemical unit 50.

The primary accelerator 20, preferably an accelerator of the LINAC type (Linear ACcelerator) or cyclotron, produces a beam of particles 21 (for example protons) which is sent on a target 22 where a main reaction takes place such as X(p,y)Z, that is a reaction causing a material X to be transformed (induced by protons p with emission of particles y) into a material Z.

In the example of figure 4, the target 22 comprises a heat exchanger 1 of the type described above. In detail, the target 22 comprises a plate 2 on whose lower face 5 the material X (denoted by numeral 220) is deposited, e.g. Nickel or better enriched Nickel, such as Ni-64.

The heat exchanger of figure 4 comprises microtubes 10 placed inside the plate 2 and connected to means 221 for the circulation of the cooling fluid, for example a pump.

During irradiation, the material X gets warm due to the absorbed power; in this phase, means 221 control the circulation of the cooling fluid such to keep the temperature of the target within predetermined values depending on the desired reaction. For example is CU-64 is desired (a radionuclide currently tested as a radiopharmaceutical, but usable also in PET - Positron Emission Tomography - as a marker), a target of Nickel and Nickel-64 is irradiated. Since the melting temperature of the Nickel is about 1450 °C , by using the diamond for the plate 2, it is possible to operate at temperatures of about 800 °C. Finite element conservative calculations denote that in the stationary state, an exchanger made with a copper plate of 2x2 cm dimensions and comprising 13 microtubes wherein water flows as the cooling fluid, is able to keep the surface temperature of the nickel (having a thickness of 0.5 mm) lower than 500 degrees by dissipating a specific power of about 5kw/cm2, corresponding to a proton current of 300 µA with an energy of 35 MeV. Experimental data obtained using a bare copper heat sink, irradiated in vacuum with 2.8 MeV proton beam, has showed that the maximum surface temperature of 100 C has been obtained transferring 3 kW/cmq. The cooling fluid used was sanitary water at 10 C inlet temperature and about 3.5 bar of pressure.

After a suitable exposure time, the radiopharmaceutical Z is therefore separated from the material X according to radiochemistry techniques known per se, for example the CU-64 can be separated from the Nickel substrate by ion exchange chromatography.

A further preferred and advantageous application of the heat exchanger 1 according to the present invention is that for cooling heat engines, particularly combustion engines of motor vehicles and motorcycles.

According to such application, a heat engine, particularly a combustion engine, comprises at least one engine block comprising at least one cylinder with a piston intended to slide therein and a cylinder head, which is placed at one end of the engine block, and it is intended to house at least one valve for the intake of fuel in the cylinder. The heat exchanger 1 is placed on the cylinder head or on the engine block such to cool them.

The heat exchanger of the present invention has also a preferred and advantageous application in a BNCT (BORON NEUTRON CAPTURE THERAPY) or ABNCT.

In detail, the heat exchanger is applied on the power target, that is on the target used for producing neutrons. Preferably the heat exchanger is applied on a target composed of a deposit of lithium and it is used for cooling it. Conservative calculations and first experimental evidences have shown that by using as the neutron generator (n) the reaction 7Li(p,n) with a thickness of 50 µm of lithium and proton beam energy of 1.9 meV, it is possible to dissipate a specific power of about 4 kw/cm² while keeping the temperature of the lithium lower than the melting temperature of the lithium 180°C.

From the above description, it is clear how the method for producing a heat exchanger and the relevant heat exchanger described allow the proposed objects to be achieved.

Particularly, advantageously:
- by the method of the present invention it is possible to form microchannels that are also very long, with desired (constant or variable) directions and dimensions and with different geometries (square ones, ellipsoidal ones, semicircular ones, etc), a thing that was not possible with the electrical discharge machining perforation that limited the shape of the microchannel only to the circular section and that prevented perfectly straight holes from being perforated due to mechanical tolerances;
- the constructional method according to the present invention allows heat exchangers to be made with any dimensions and with very small thicknesses of the walls, thus considerably improving heat conduction properties;
- the use of the liquid metal as the cooling fluid allows a gain of at least a factor of 3 than water since it considerably increases the convective coefficient (defined as h = lambda/Nu, where lambda is the thermal conduction coefficient); the different mode for transferring the heat with respect to water (convection vs thermal conduction) allows high values of h to be obtained also in presence of a laminar motion (low Reynolds number);
- the use of the diamond then provides considerably better performances both as regards heat transfer and mechanical resistance of the object; according to the current experimental data, the heat exchanger of the present invention has performances higher more than one order of magnitude than prior art exchangers for the dissipation of high specific powers;
- the heat exchanger according to the present invention is easy and inexpensive to be produced.

Therefore it is clear for a person skilled in the art that it is possible to make modifications and changes to the solution described with reference to figures 1 to 4, without for this reason departing from the teaching of the present patent and from the scope of protection as defined in the annexed claims.

For example it is clear for the person skilled in the art how it is possible to use materials of the plate 2 and of the tube 10, arrangements of the microchannels 3 and types of cooling fluids different from those mentioned with reference to the shown embodiments depending on the operating conditions and on the devices to be cooled.

It is also clear that, although in the above examples the microchannels 3 are formed through only one face, they can be formed on one or more faces of the plate 2 in order to increase the heat exchange capacity of the exchanger 1. For example the microchannels can be formed on two opposite faces (e.g. faces 4 and 5) or contiguous faces (e.g. faces 4 and 7).

Moreover even if the embodiments described above with reference to figures 1 to 4 provide the opening 33 to remain open, according to one variant, such opening can be closed after forming the microchannel 3, with its blind extremity 32 being shaped. Preferably the opening 33 is closed by means of a thermally conductive material, particularly a metal with a good thermal diffusivity for example a metal, after the tube has been inserted in the microchannel, thus the filling material used for closing the opening 33 further fixes the tube 10 in its seat.

In one embodiment, one or more of the tubes 10 that are inserted in the microchannels 3 are closed at their ends to form a closed circuit within which the cooling fluid can flow. Thus the closed tubes form "heat pipe" able to transfer heat from one end (hot) to another end (cold) of the tube, by the evaporation and condensation of the cooling fluid within the tube itself.

## Claims

1. Method for producing a heat exchanger (1), comprising the steps of:
- making at least one channel (3) within a plate (2) having an upper face (4) and a lower face (5), said channel (3) extending inside the plate (2) between the upper face (4) and the lower face (5),
- inserting (104) a tube (10) inside the channel (3) and
- generating (105) interference between the tube (10) and the channel (3) so as to fix the tube (10) inside the channel (3), whereby the channel (3) is made according to the following steps:
a) making (102) a groove on the upper face (4) of the plate (2), said groove extending between an open extremity (31) facing on the upper face (4) and a blind extremity (32) placed inside the plate (2),
b) machining (103) the blind extremity (32) of the groove to create a volume of a suitable size to house the tube (10),
the method being **characterized in that** the channel is a microchannel.

2. Method according to claim 1, wherein both the groove according to step a) and the machining of the blind extremity (32) of the groove according to step b) are performed by means of wire electric discharge machining.

3. Method according to claim 1, wherein the microchannel is made by milling the plate using a milling cutter comprising a thin body with an enlarged head towards a free end of the milling cutter, the method providing to mill the plate by means of a relative movement of the milling cutter in a plane orthogonal to the upper face of the plate, so that the thin body of the milling cutter creates the groove referred to in step a) while the enlarged head of the milling cutter performs the machining of step b).

4. Method according to any one of the preceding claims, wherein the tube (10) has a diameter greater than the width of the groove present in the upper face (4) of the plate, and wherein the tube (10) is inserted into the microchannel (3) through an opening of the groove in a transverse wall of the plate (2), said transverse wall extending between the upper face (4) and the lower face (5) of the plate.

5. Method according to any one of claims 1 to 3, wherein the microchannel (3) has, in a plane transverse to the upper face (4), a section in the shape of a polygon (9), and wherein the tube (10) is inserted into the microchannel (3) by pressure through the opening of the groove on the upper face (4) of the plate (2).

6. Method according to any one of the preceding claims, wherein the materials of the plate (2) and of the tube (10) have a high thermal diffusivity and are such that the thermal expansion coefficient of the plate (2) is lower than the tube (10) one.

7. Method according to any one of the preceding claims, wherein the materials of plate (2) and of the tube (10) are such to allow wire drawing of the tube (10) inside the microchannel (3) of the plate (2).

8. Method according to any one of the preceding claims, wherein at least two microchannels (3) are made on two different faces of the plate, each one of said at least two microchannels (3) being provided with an open extremity on a respective face and with a blind extremity placed inside the plate (2).

9. Method according to any one of the preceding claims, wherein the tube (10) is closed at the ends to form a closed circuit within which the cooling fluid can flow.

10. Method according to any one of the preceding claims, further comprising the step of closing the open extremity (33) of the groove by means of thermally conductive material.

11. Heat exchanger (1) comprising:
- a plate (2), in turn comprising:
- an upper face (4) and a lower face (5), and
- at least one channel (3) developing inside the plate (2) between the upper face (4) and the lower face (5),
- a tube (10) inserted inside the channel (3) and fixed thereto, whereby said at least one channel (3) has, throughout its development length, an opening (31) which opens on the upper face (4) of the plate (2), and in that the opening has such a dimension that does not allow the tube to come out through said opening,
**characterized in that** the channel is a microchannel.

12. Heat exchanger (1) according to claim 11, wherein the plate (2) is made of silicon and it comprises electronic components.

13. Heat exchanger (1) according to any one of claims 11 to 12, wherein said tube (10) is a capillary tube having a diameter of less than 100 µm.

14. Apparatus (100) for the production of radionuclides comprising:
- a primary accelerator (20) to accelerate a beam of particles,
- a target (22) positioned along a trajectory of said beam of particles,
**characterized in that** the target (22) comprises a heat exchanger according to any of claims 11 to 13.

15. Use of the heat exchanger (1) according to any one of claims 11 to 13 for cooling a heat engine, in particular a combustion engine, comprising at least one engine block comprising at least one cylinder with a piston intended to slide therein and a cylinder head, placed at one end of the engine block, and intended to house at least one valve for the intake of fuel into the cylinder, wherein said heat exchanger (1) is positioned on the cylinder head or on the engine block.

## Patentansprüche

1. Verfahren zur Herstellung eines Wärmetauschers mit den Schritten:
- Erzeugen wenigstens eines Kanals (3) in einer Platte (2), die eine Oberseite (4) und eine Unterseite (5) hat, wobei der Kanal (3) sich in der Platte (2) zwischen der Oberseite (4) und der Unterseite (5) erstreckt,
- Einfügen (104) eines Rohrs (10) in den Kanal (3) und
- Bewirken (5) eines Eingriffs zwischen dem Rohr (10) und dem Kanal (3), sodass das Rohr (10) in dem Kanal (3) fixiert ist, wobei der Kanal (3) durch die folgenden Schritte hergestellt ist:
a) Erzeugen (102) einer Nut an der Oberseite (4) der Platte (2), wobei sich die Nut zwischen einer offenen Seite (31), die der Oberseite (4) zugewandt ist, und einer geschlossenen unteren Seite (32), die sich in der Platte (2) befindet, erstreckt,
b) Bearbeiten (103) der geschlossenen Seite (32) der Nut, um ein Volumen ausreichender Größe zum Aufnehmen des Rohrs (10) zu erzeugen,
wobei das Verfahren **dadurch gekennzeichnet ist, dass** der Kanal ein Mikrokanal ist.

2. Verfahren nach Anspruch 1, wobei sowohl die Nut nach Schritt a) und das Bearbeiten der geschlossenen unter Seite (32) der Nut nach Schritt b) mittels Funkenerosion erzeugt werden.

3. Verfahren nach Anspruch 1, wobei der Mikrokanal durch Fräsen der Platte mittels eines Fräswerkzeugs hergestellt wird, das einen dünnen Körper mit einem vergrößerten Kopf hin zu einem freien Ende des Fräswerkzeugs aufweist, wobei das Verfahren des Fräsens der Platte mit einer relativ Bewegung des Fräswerkzeugs in einer Ebene senkrecht zu der Oberseite der Platte erfolgt, sodass der dünne Körper des Fräswerkzeugs die im Schritt a) wird Nut erzeugt, während der vergrößerte Kopf die Bearbeitung gemäß schritt b) vornimmt.

4. Verfahren nach einem der vorstehenden Ansprüche, wobei das Rohr (10) einen Durchmesser hat, der größer als die Breite der Nut an der Oberseite (4) der Platte ist, und wobei das Rohr (10) in den Mikrokanal (3) durch eine Öffnung der Nut in einer Seitenwand der Platte (2) eingeführt wird, wobei sich die Seitenwand zwischen der Oberseite (4) und der Unterseite (5) der Platte erstreckt.

5. Verfahren nach einem der Ansprüche 1 bis 3, wobei der Mikrokanal (3) in einer Ebene senkrecht zu der Oberseite (4) einen Abschnitt in Form eines Polygons (9) hat, und wobei das Rohr (10) den Mikrokanal (3) mittels Druck durch die Öffnung der Nut an der Oberseite (4) der Platte (2) eingeführt wird.

6. Verfahren nach einem der vorstehenden Ansprüche, wobei die Materialien der Platte (2) und des Rohrs (10) an eine ausreichend große Wärmeleitfähigkeit haben und so beschaffen sind, dass der Wärmeausdehnungskoeffizient der Platte (2) kleiner als der des Rohrs (10) ist.

7. Verfahren nach einem der vorstehenden Ansprüche, wobei die Materialien der Platte (2) und des Rohrs (10) so sind, dass sie Drahtziehen des Rohrs (10) in dem Mikrokanal (3) der Platte (2) ermöglichen.

8. Verfahren nach einem der vorstehenden Ansprüche, wobei die wenigstens zwei Mikrokanäle (3) auf zwei verschiedenen Seiten der Platte hergestellt werden, wobei jede der wenigstens zwei Mikrokanäle (3) mit einer offenen Seite auf einer entsprechenden Seite und eine geschlossenen Seite, die in der Platte (2) angeordnet ist, versehen ist.

9. Verfahren nach einem der vorstehenden Ansprüche, wobei das Rohr (10) an den Enden geschlossen ist, um ein geschlossenen Kreislauf zu erzeugen, in dem Kühlflüssigkeit fließen kann.

10. Verfahren nach einem der vorstehenden Ansprüche, zusätzlich mit dem Schritt des Schließens der offenen Seite (33) der Nut mittels eines wärmeleitfähigen Materials.

11. Wärmetauscher (1) mit:
- einer Platte (2), die wiederum aufweist:
- eine Oberseite (4) und einer Unterseite (5) sowie
- wenigstens einen Kanal (3), der sich in der Platte (2) zwischen der Oberseite (4) und der Unterseite (5) erstreckt,
- einem Rohr (10), das in den Kanal (3) eingeführt und daran befestigt ist,
wobei der wenigstens eine Kanal (3) über seine gesamte Länge eine Öffnung (31) hat, die sich zu der Oberseite (4) der Platte (2) hin öffnet, und wobei die Öffnung eine solche Abmessung hat, dass das Rohr nicht hin durch diese Öffnung hindurchgelangen kann, **dadurch gekennzeichnet, dass** der Kanal eine Mikrokanal ist.

12. Wärmetauscher (1) nach Anspruch 11, wobei die Platte (2) aus Silizium ist und elektrische Komponenten aufweist.

13. Wärmetauscher (1) nach einem der Ansprüche 11 bis 12, wobei das Rohr (10) ein Kapillarrohr mit einem Durchmesser von weniger als 100 µm ist.

14. Vorrichtung (100) zur Herstellung von Radionukliden, mit:
- einem primären Beschleuniger (20), um einen Teilchenstrahl zu beschleunigen,
- einem Target (22), das in der Bahn des Teilchenstrahls angeordnet ist,
**dadurch gekennzeichnet, dass** das Target (22) einen Wärmetauscher nach einem der Ansprüche 11-13 enthält.

15. Verwendung eines Wärmetauschers (1) nach einem der Ansprüche 11 bis 13 zum Kühlen einer Wärmekraftmaschine, insbesondere eines Verbrennungsmotors, mit wenigstens einem Motorblock, der wenigstens einen Zylinder mit einem Kolben, der dazu vorgesehen ist, sich darin zu bewegen, und einen Zylinderkopf, der an einem Ende des Motorblocks angeordnet und dafür vorgesehen ist, wenigstens ein Ventil zum Einlass von Brennstoff in den Zylinder aufzunehmen, aufweist, wobei der Wärmetauscher (1) an dem Zylinderkopf oder an dem Motorbock angeordnet ist.

## Revendications

1. - Procédé pour produire un échangeur de chaleur (1), comprenant les étapes :
- réaliser au moins un canal (3) dans une plaque (2) ayant une face supérieure (4) et une face inférieure (5), ledit canal (3) s'étendant à l'intérieur de la plaque (2) entre la face supérieure (4) et la face inférieure (5),
- introduire (104) un tube (10) à l'intérieur du canal (3), et
- générer (105) une interférence entre le tube (10) et le canal (3) de façon à fixer le tube (10) à l'intérieur du canal (3),
ce par quoi le canal (3) est réalisé selon les étapes suivantes :
a) réaliser (102) une rainure sur la face supérieure (4) de la plaque (2), ladite rainure s'étendant entre une extrémité ouverte (31) débouchant sur la face supérieure (4) et une extrémité borgne (32) placée à l'intérieur de la plaque (2),
b) usiner (103) l'extrémité borgne (32) de la rainure pour créer un volume d'une taille appropriée pour recevoir le tube (10),
le procédé étant **caractérisé par le fait que** le canal est un microcanal.

2. - Procédé selon la revendication 1, dans lequel la rainure selon l'étape a) et l'usinage de l'extrémité borgne (32) de la rainure selon l'étape b) sont réalisés au moyen d'une gravure par étincelage.

3. - Procédé selon la revendication 1, dans lequel le microcanal est réalisé par fraisage de la plaque à l'aide d'une fraise comprenant un corps mince avec une tête agrandie vers une extrémité libre de la fraise, le procédé prévoyant de fraiser la plaque au moyen d'un mouvement relatif de la fraise dans un plan orthogonal à la face supérieure de la plaque, de telle sorte que le corps mince de la fraise crée la rainure à laquelle il est fait référence à l'étape a) tandis que la tête agrandie de la fraise réalise l'usinage de l'étape b).

4. - Procédé selon l'une quelconque des revendications précédentes, dans lequel le tube (10) a un diamètre supérieur à la largeur de la rainure présente dans la face supérieure (4) de la plaque, et le tube (10) est introduit dans le microcanal (3) à travers une ouverture de la rainure dans une paroi transversale de la plaque (2), ladite paroi transversale s'étendant entre la face supérieure (4) et la face inférieure (5) de la plaque.

5. - Procédé selon l'une quelconque des revendications 1 à 3, dans lequel le microcanal (3) a, dans un plan transversal à la face supérieure (4), une section sous la forme d'un polygone (9), et le tube (10) est introduit dans le microcanal (3) par pression à travers l'ouverture de la rainure sur la face supérieure (4) de la plaque (2).

6. - Procédé selon l'une quelconque des revendications précédentes, dans lequel les matériaux de la plaque (2) et du tube (10) ont une diffusivité thermique élevée et sont tels que le coefficient de dilatation thermique de la plaque (2) est inférieur à celui du tube (10) .

7. - Procédé selon l'une quelconque des revendications précédentes, dans lequel les matériaux de la plaque (2) et du tube (10) sont tels qu'ils permettent un tréfilage du tube (10) à l'intérieur du microcanal (3) de la plaque (2).

8. - Procédé selon l'une quelconque des revendications précédentes, dans lequel au moins deux microcanaux (3) sont réalisés sur deux faces différentes de la plaque, chacun desdits au moins deux microcanaux (3) comportant une extrémité ouverte sur une face respective et une extrémité borgne placée à l'intérieur de la plaque (2).

9. - Procédé selon l'une quelconque des revendications précédentes, dans lequel le tube (10) est fermé aux extrémités pour former un circuit fermé à l'intérieur duquel le fluide de refroidissement peut s'écouler.

10. - Procédé selon l'une quelconque des revendications précédentes, comprenant en outre l'étape de fermeture de l'extrémité ouverte (33) de la rainure au moyen d'un matériau thermoconducteur.

11. - Échangeur de chaleur (1) comprenant :
- une plaque (2), comprenant à son tour :
- une face supérieure (4) et une face inférieure (5), et
- au moins un canal (3) se développant à l'intérieur de la plaque (2) entre la face supérieure (4) et la face inférieure (5),
- un tube (10) introduit à l'intérieur du canal (3) et fixé à celui-ci,
ce par quoi ledit au moins un canal (3) a, sur toute sa longueur de développement, une ouverture (31) qui débouche sur la face supérieure (4) de la plaque (2), et l'ouverture ayant une dimension telle qu'elle ne permet pas au tube de sortir à travers ladite ouverture,
**caractérisé par le fait que** le canal est un microcanal.

12. - Échangeur de chaleur (1) selon la revendication 11, dans lequel la plaque (2) est faite de silicium et elle comprend des composants électroniques.

13. - Échangeur de chaleur (1) selon l'une quelconque des revendications 11 à 12, dans lequel ledit tube (10) est un tube capillaire ayant un diamètre de moins de 100 µm.

14. - Appareil (100) pour la production de radionucléides, comprenant :
- un accélérateur primaire (20) pour accélérer un faisceau de particules,
- une cible (22) positionnée le long d'une trajectoire dudit faisceau de particules,
**caractérisé par le fait que** la cible (22) comprend un échangeur de chaleur selon l'une quelconque des revendications 11 à 13.

15. - Utilisation de l'échangeur de chaleur (1) selon l'une quelconque des revendications 11 à 13 pour refroidir un moteur thermique, en particulier un moteur à combustion, comprenant au moins un bloc-moteur comportant au moins un cylindre avec un piston destiné à coulisser à l'intérieur de celui-ci et une culasse, placée au niveau d'une extrémité du bloc-moteur, et destinée à recevoir au moins une soupape pour l'admission de carburant dans le cylindre, ledit échangeur de chaleur (1) étant positionné sur la culasse ou sur le bloc-moteur.
